# DEMANDE DE BREVET EUROPEEN

(11) **EP 4 741 925 A1**
(43) Date de publication de la demande: **13.05.2026**
(21) Numéro de dépôt: 24212405.5
(22) Date de dépôt: 12.11.2024
(51) Int. Cl.: G03F 7/00, G03F 7/105, G04B 19/12, G04B 45/00

(54) **PROCÉDÉ DE FABRICATION D'UN COMPOSANT COMPORTANT UN MOTIF DE MICROSTRUCTURE SUR UNE RÉSINE COLORÉE ET COMPOSANT OBTENU PAR LEDIT PROCÉDÉ**

(71) Demandeur: CSEM Centre Suisse d'Electronique et de Microtechnique SA - Recherche et Développement, 2000 Neuchâtel (CH)
(72) Inventeur: Blondiaux, Nicolas, 2206 Les Geneveys-sur-Coffrane (CH); Pugin, Raphaël, 2013 Colombier (CH)
(74) Mandataire: P&TS SA (AG, Ltd.)

(57) **Abrégé**

La présente divulgation concerne un procédé de fabrication d'un composant comportant un motif de microstructure sur une résine colorée, comprenant:
fournir un moule d'impression (30) comportant un motif de moule (32) comprenant des éléments de structuration ayant une dimension de taille micrométrique et/ou nanométrique;
fournir un substrat (10) et former une couche de résine (20) colorée sur un substrat (10), la résine comportant au moins un agent colorant;
répliquer sur la couche de résine (20) un motif répliqué (22) correspondant au négatif du motif de moule (32), comprenant l'application du moule d'impression (30) contre la couche de résine (20); et
réticuler la résine (20) de manière à produire une résine durcie comportant le motif répliqué (22).

Le motif de moule (32) comprend des éléments de structuration ayant une dimension latérale moyenne entre 1 nm et 5000 µm, et un rapport d'aspect entre la hauteur des éléments de structuration et la dimension latérale moyenne entre environ 0.1 et 2.

## Description

### Domaine technique

La présente divulgation concerne la fabrication d'un composant comportant un motif de microstructure sur une résine colorée. Notamment, le composant peut comprendre un composant horloger, un composant de joaillerie, un composant micromécanique, un élément de sécurité et/ou d'anticontrefaçon, ou un composant décoratif. En particulier, la présente divulgation concerne la fabrication d'un cadran horloger comprenant un tel motif de microstructure.

### Etat de la technique

Des laques colorés ou des empilements de films minces réalisés par PVD/ALD sont couramment utilisées pour contrôler la couleur des cadrans de montre. Alors que les empilements de films minces peuvent être aussi minces que quelques centaines de nanomètres à quelques micromètres, une grande épaisseur, jusqu'à 100 micromètres, est nécessaire pour les laques. En pratique, seuls les empilements de films minces peuvent être utilisés pour recouvrir de manière conforme un motif guilloché ou usiné ou des textures de surfaces (soleillage, sablage, microbillage, etc.) qui présente des crêtes avec des dimensions latérales de quelques micromètres à quelques millimètres et des profondeurs de quelques dizaines de micromètres pour lui conférer une couleur tout en conservant l'effet optique décoratif apporté par le motif usiné. L'application d'une laque sur de tels motifs entraîne une perte de netteté du motif et une dégradation de l'effet optique produit par le guillochage ou le motif usiné.

De plus, bien que la palette de couleurs pour les empilements de films minces s'améliore constamment, chaque couleur nécessite une conception spécifique pour atteindre le bon pantone et éviter les changements de couleurs lors d'une variation d'angle. De plus, l'effet final est difficile à anticiper sur des surfaces structurées. Certaines couleurs, comme le rouge chaud, sont également difficiles à obtenir par les techniques de dépôts de films minces.

Le document CH709669A1 décrit l'utilisation d'une combinaison de couche PVD partiellement réféchissante avec une couche mince ALD afin d'obtenir une gamme de couleurs interférentielle allant des bruns, magenta, bleu , jaune, orange, violet, vert, rose selon l'épaisseur de la couhce ALD. La couche PVD sousjacente permet de modulet la clareté de la couleur.

Afin de s'affranchir de la dépendance angulaire, il est possible d'introduire une rugosité de surface sous l'empilement de couches minces (voir par exemple, Bläsi, T. Kroyer, T. E. Kuhn and O. Höhn, "The MorphoColor Concept for Colored Photovoltaic Modules," in IEEE Journal of Photovoltaics, vol. 11, no. 5, pp. 1305-1311, 2021). D'un point de vue industriel, l'épaisseur des couches dépendant de la surface spécifique des pièces à traiter, ceci peut engendrer des problèmes de reproductibilité ou de flexibilité lors du traitement de pièces structurées/texturées.

D'autres exemples d'empilement de couches déposées sous vide existent donnant lieu à des effets optiques sans dépendance angulaire. Il est par exemple possible de déposer des couches colorées par PVD en se basant sur des oxydes métalliques ou plus généralement des couches semi-absorbantes et des couches diélectriques transparentes. Cette approche est utilisée dans le document EP2392689A1 afin de réaliser une coloration rouge particulière. Pour ce faire, un film d'oxyde de fer est déposé par PVD et combiné avec une couche transparente.

D'autres méthodes de coloration sont possibles, comme par exemple la fabrication de verre colloidaux. L'effet obtenu est très attrayant car exempt de dépence angulaire mais la palette de couleurs reste limitée (voir par exemple, S. Magkiriadou, J. Park, Y.S. Kim, and V.N. Manoharan·On the Absence of Red Structural Color in Photonic Glasses, Bird Feathers and Certain Beetles, Phys. Rev. E 90, 062302 .

### Résumé de la divulgation

La présente divulgation concerne un procédé de fabrication d'un composant comportant un motif de microstructure sur une résine colorée, comprenant:
fournir un moule d'impression comportant un motif de moule comprenant des éléments de structuration ayant une dimension de taille micrométrique et/ou nanométrique;
fournir un substrat et former une couche de résine colorée sur un substrat, la résine comportant au moins un agent colorant;
répliquer sur la couche de résine un motif répliqué correspondant au négatif du motif de moule, comprenant l'application du moule d'impression contre la couche de résine; et
réticuler la résine de manière à produire une résine durcie comportant le motif répliqué.

Le motif de moule comprend des éléments de structuration ayant une dimension latérale moyenne entre 1 nm et 5000 µm, et un rapport d'aspect entre la hauteur des éléments de structuration et la dimension latérale moyenne entre 0 et 10, par exemple entre 0.1 et 10, entre 0.5 et 5, ou encore entre 0.5 et 2.

Le composant peut comprendre un composant horloger, un composant de joaillerie, un composant micromécanique, un élément de sécurité et/ou d'anticontrefaçon, ou un composant décoratif.

La présente divulgation concerne en outre un cadran de montre obtenu par le procédé et comprenant un tel motif de microstructure.

### Brève description des figures

Des exemples de mise en oeuvre de l'invention sont indiqués dans la description illustrée par les figures annexées dans lesquelles :
la figure 1 montre une couche de résine formée sur un substrat et un moule d'impression comportant un motif de moule; selon un mode de réalisation;
la figure 2 montre un étape de réplication comprenant l'application d'une surface structurée avec le motif de moule du moule d'impression contre une surface d'impression de la couche de résine, selon un mode de réalisation;
la figure 3 montre une colonne d'estampage pour réaliser l'étape de réplication;
la figure 4 montre l'illumination de la résine pendant une étape de réticulation de la résine, selon un mode de réalisation;
la figure 5 montre la couche de résine réticulée comportant un motif répliqué et séparée du moule d'impression; et
les figure 6a-c montrent des exemples du moule d'impression avec son motif de moule (haut) ainsi que le motif répliqué (bas), correspondant à un motif comprenant des angles (figure 6a), de type hémisphérique (figure 6b), et de type à créneaux (figure 6c).
les figure 7a et b montrent des exemples du moule d'impression avec son motif de moule (haut) ainsi que le motif répliqué (bas), correspondant à structures inclinées droites (figure 7a) et courbes (figure 7b) produisant un effet de dégradé de couleur; et
la figure 8 montre le motif répliqué étant recouvert par une couche additionnelle.

### Description détaillée

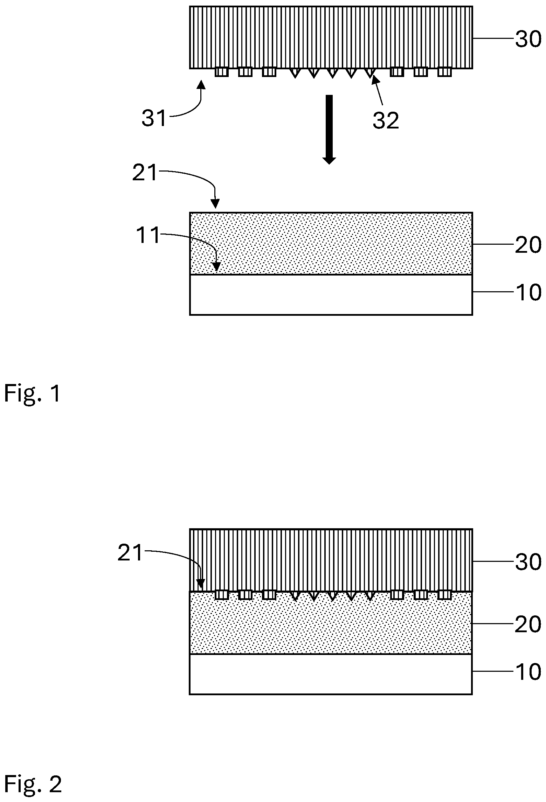

Selon un mode de réalisation illustré aux **figures 1 à 5**, un procédé de fabrication d'un composant comportant un motif de microstructure sur une résine colorée. Le procédé comprend les étapes de :
fournir un moule d'impression 30 comportant un motif de moule 32 comprenant des éléments de structuration ayant une dimension de taille micrométrique et/ou nanométrique;
fournir un substrat 10 et former une couche de résine 20 colorée sur le substrat 10, la résine 20 comportant au moins un agent colorant ;
répliquer sur la couche de résine 20 un motif répliqué 22 correspondant au négatif du motif de moule 32, comprenant l'application du moule d'impression 30 contre la couche de résine 20; et
réticuler (durcir) la résine 20 de manière à produire une résine durcie comportant le motif répliqué 22.

La **figure 1** montre la couche de résine 20 formée sur une surface supérieure 11 du substrat 10, et le moule d'impression 30 comportant le motif de moule 32 du côté d'une surface structurée 31 du moule d'impression 30. Afin d'assurer une bonne adhésion entre la résine 20 et le substrat 10, une couche d'apprêt (ou couche d'amorce ou primaire) peut être formée sur le substrat 10 préalablement à la formation de la couche de résine 20. L'application de la couche de résine 20 sur la surface supérieure 11 du substrat 10 peut être réalisée à l'aide d'une méthode de dispense, par exemple une par « spin coating » dans laquelle des couches de résine 20 sont étalées sur le centre du substrat 10 puis étalée par rotation du substrat 10 autour d'un axe central.

### Réplication

La **figure 2** montre l'étape de réplication comprenant l'application de la surface structurée 31 avec le motif de moule 32 du moule d'impression 30 contre une surface d'impression 21 de la couche de résine 20. Selon une forme d'exécution, une pression de l'ordre de 10 à 30 kPa est appliquée entre le moule d'impression 30 et la couche de résine 20. De manière générale, l'application du moule d'impression 30 contre la couche de résine 20 est réalisée de façon que les saillies du motif de moule 32 pénètre bien dans la résine 20 et que les cavités du motif de moule 32 soient entièrement remplis de résine 20 (sans formation de poche d'air).

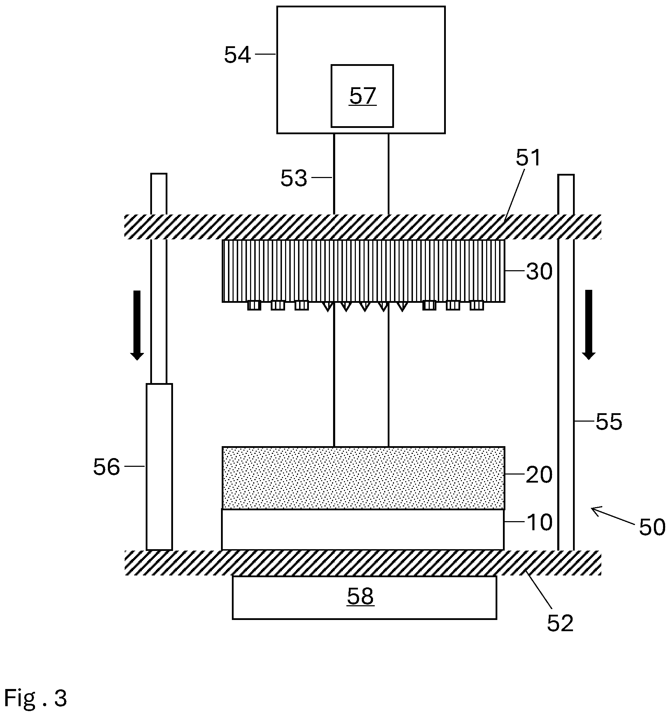

L'étape de réplication peut être réalisée à l'aide d'une colonne d'estampage 50, comme illustré à la **figure 3****.** La colonne d'estampage 50 peut comporter un support de moule 51 sur lequel est fixé le moule d'impression 30 et un support de résine 52 sur lequel sont fixés le substrat 10 et la résine 20. Le support de moule 51 se déplace sensiblement verticalement par rapport au support de résine 52 grâce à une colonne montante et descendante 53 pouvant être entraînée par un moteur d'entrainement 54. Le mouvement du support de moule 51 peut être guidé par une ou des colonnes de guidage 55 de sorte que le support de moule 51 reste aligné avec le support de résine 52. Ce dernier est fixe par rapport à la colonne montante et descendante 53. La colonne montante et descendante 53 permet d'amener le moule d'impression 30 en contact avec la résine 20 et d'appliquer une pression comme définie ci-dessus.

En comparaison à un procédé de réplication avec une résine thermique, le procédé par réplication avec une résine réticulable aux UV permet une plus grande fidélité du motif répliqué 22 sur la résine 20 par rapport au motif de moule 32. Cela s'explique par le fait que la réplication est réalisée à température ambiante ou basse température, par exemple entre 20 et 80°C. La résine réticulable est typiquement liquide (viscosité faible) et peuvent ainsi mieux épouser les motifs du moule avant photoréticulation. Par ailleurs, les résines photodurcissables présentent en général un taux de retrait (dû à a réaction chimique de réticulation) inférieur aux résines thermodurcissables, ce qui facilite le démoulage. Dans le cas de la réplication avec une résine thermique, les températures élevés provoquent aussi une dilatation thermique de la résine, rendant l'étape de démoulage problématique (voir ci-dessous).

### Résine

Selon une forme d'exécution, la résine 20 comprend une résine photoréticulable par UV (ou résine durcissable aux UV). Par exemple, la résine 20 peut comprendre au moins l'un des monomères d'acrylate, des oligomères d'acrylate, des époxydes, de la silicone ou de l'acrylate de silicone. La résine 20 peut également comprendre un sol/gel ou un monomère d'acrylate et de silice ainsi que des charges inorganique (nanoparticules de silice, d'alumine ou titane) afin d'en modifier les propriétés mécaniques et optiques.

Selon une autre forme d'exécution, la résine 20 est une résine thermodurcissable. L'étape de réticuler la résine peut alors être réalisé en chauffant la résine à une température de réticulation (T_{R}). La température de réticulation dépend de la nature chimique de la résine et de la présence de thermoinitiateur (typiquement des TAG (pour *Thermal Acid Generator).* Typiquement, une température de réticulation de 20 à 200°C est utilisée, plus précisément de 20 à 160°C

La couche de résine colorée 20 peut avoir une épaisseur entre 10 µm et 500 µm. L'épaisseur de la couche de résine colorée 20 doit être ajustée pour obtenir l'effet de couleur recherché. Par exemple, la couche de résine colorée 20 devra avoir une épaisseur suffisante pour que la quantité d'agent colorant soit suffisante dans l'épaisseur de la couche de résine 20 pour obtenir la densité de couleur voulue.

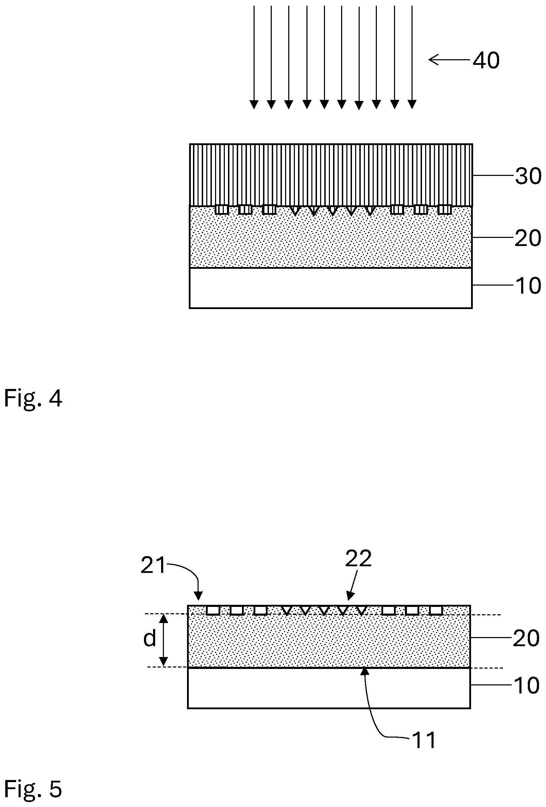

L'épaisseur de la couche de résine peut être ajustée de manière à obtenir une épaisseur minimale d de la couche de résine 20 comportant le motif répliqué. Par exemple, l'épaisseur minimale d peut correspondre à l'épaisseur de la couche de résine 20 au niveau du creux le plus profond du motif répliqué (voir la figure 5). L'épaisseur minimale d permet d'assurer une quantité d'agent colorant suffisante dans l'épaisseur de la couche résine 20, de manière à obtenir la coloration souhaitée.

L'épaisseur minimale d peut être contrôlée pendant l'étape de réplication en contrôlant la distance entre le moule d'impression 30 et la surface supérieure 11 du substrat 10. Selon une forme d'exécution, la colonne d'estampage 50 peut être pourvue d'au moins une butée 56 (voir la figure 5) configurée pour venir en appui contre le support de moule 51, lors de l'étape de réplication, de sorte que la structure la plus saillante du motif de moule 32 soit à une distance de le surface supérieure 11 du substrat 10 qui correspond à l'épaisseur minimale d.

### Réticulation

La **figure 4** montre l'irradiation de la résine 20 photoréticulable avec l'illumination UV 40. Selon la forme d'exécution illustrée à la figure 4, l'étape de réticulation de la résine 20 est réalisée avant l'étape de séparation, avec le moule d'impression 30 toujours en contact avec la résine 20. Dans l'exemple illustré où le moule d'impression 30 s'interpose entre l'illumination 40 et la résine 20, le moule d'impression 30 doit être suffisamment transparent au spectre d'émission de l'illumination UV 40 pour pouvoir réticuler la couche de résine 20 dans toute son épaisseur. Par exemple, le moule d'impression 30 peut comprendre un verre ou un polymère transparent au spectre d'émission de l'illumination 40.

Dans un autre mode de réalisation non illustré, l'irradiation de la résine 20 peut être réalisé à travers le substrat 10. Dans ce cas, le substrat 10 doit être suffisamment transparent au spectre d'émission de l'illumination UV 40 pour pouvoir réticuler la couche de résine 20 dans toute son épaisseur.

Selon une forme d'exécution, la colonne d'étampage 50 comprend un système d'irradiation 57 fournissant l'illumination UV 40. En référence à la figure 3, la colonne d'estampage 50 peut être configurée pour laisser passer l'illumination UV 40 au travers du support de moule 51 et moule d'impression 30, jusqu'à la couche de résine 20.

Dans le cas où la résine 20 comprend une résine thermodurcissable, l'étape de réticuler la résine peut alors être réalisé en chauffant la résine 20 via un élément chauffant 58 arrangé à proximité de la résine 20. L'élément chauffant 58 est configuré pour pouvoir chauffer la résine à la température de réticulation T_{R}.

Le procédé de fabrication peut également comprendre une étape de post-durcissement (post curing) afin de s'assurer de la réticulation complète de la résine. L'étape de post-durcissement peut comprendre une irradiation supplémentaire ou un chauffage supplémentaire, selon que la résine est photoréticulable ou thermodurcissable ou les deux.

Lors de l'étape de réticulation, l'intensité du rayonnement UV 40 peut être ajustée afin de prendre en compte la présence de l'agent colorant dans la résine 20. Par, exemple, l'intensité du rayonnement UV 40 pour la résine comprenant l'agent colorant sera plus élevé que dans le cas d'une résine sans agent colorant. L'intensité du rayonnement UV 40 est également ajustée selon l'épaisseur de la couche de résine. L'intensité du rayonnement UV 40 peut être ajusté via le temps d'exposition et l'irradiance. Par exemple, l'irradiance peut être entre 10 et 500 mW/cm².

Après l'étape de réticulation de la résine 20, le procédé peut également comprendre une étape de séparation de la résine réticulée comportant le motif répliqué 22 du moule d'impression 30 (étape de démoulage). La couche de résine 20 réticulée comportant le motif répliqué 22 et séparée du moule d'impression 30 est montrée à la **figure 5****.** Le motif répliqué 22 correspondant au négatif du motif de moule 32. La surface structurée 31 du moule d'impression 30 peut être traité de manière à faciliter le démoulage. Par exemple, surface structurée 31 peut être revêtue d'une couche antiadhésive.

### Agent colorant

Selon une forme d'exécution, l'agent colorant comprend un pigment inorganique. Un tel pigment permet d'obtenir une dispersion homogène du pigment (particule) dans la matrice de résine photoréticulable. La résine ainsi colorée est stable du fait que les pigments conservent leur distribution de taille initiale et ne présentent pas de phénomène d'agrégation pendant les étapes de formulation, déposition, texturation et photoréticulation. Ce paramètre est crucial pour maîtriser la stabilité de la couleur finale de la résine structurée et réticulée.

La réticulation complète de la résine pigmentée nécessite une bonne propagation des UV de l'interface avec le moule jusqu'au substrat. Ceci peut être rendu possible en maîtrisant correctement la transparence aux UV des pigments, l'indice de réfraction du pigment par rapport à la résine, et/ou la concentration de pigment dans la résine.

Le pigment peut être au moins partiellement transparent dans l'UV. Une faible absorption permet une propagation des UV dans toute l'épaisseur de la résine pigmentée. La taille du pigment par rapport à la taille du motif répliqué 22 est également à considérer. Par exemple, un pigment dont la taille est plus grande que la taille des structures micrométriques du moule d'impression 30 ne permet pas de remplir les structures du moule d'impression 30 avec la résine colorée 20, mais seulement avec la résine transparent (sans pigment). Un pigment dont la taille est au moins deux fois plus petite que la taille des structures micrométriques du moule d'impression 30 permet à la résine colorée 20 (avec les pigments) de remplir les structures du moule d'impression 30 avec la résine colorée 20. Ici, la taille des structures micrométriques peut être considérée comme la dimension latérale moyenne du motif de moule 32 (voir ci-dessous).

Contrairement à l'utilisation d'un colorant pour colorer la résine, le pigment permet d'obtenir une dispersion plutôt qu'une solution lorsqu'il est mélangé à la résine 20. Lors de l'étape de réticulation de la résine le rayonnement UV est diffusé par les particules de pigment. Si le pigment a un indice de réfraction similaire à celui de la résine, la diffusion est faible et les UV se propagent à travers la couche de résine, sous réserve que le pigment n'absorbe pas dans les UV. En cas d'une différence d'indice entre la résine et les pigments, la propagation des UV dépendra de la concentration en pigment et des propriétés diffusantes des particules (diamètre, différence d'indice de réfraction). Dans le cas d'une faible concentration en pigment, le système est décrit par un régime balistique alors qu'on parle d'un régime de diffusion multiple pour une forte concentration (G. Jacucci, L. Schertel, Y. Zhang, H. Yang, S. Vignolini, Light Management with Natural Materials: From Whiteness to Transparency.Adv. Mater. 2021, 33, 2001215). Il existe donc un compromis concernant le type de pigment et sa concentration permettant la réticulation à la résine interstitielle (entre les particules de pigment) d'être réticulée plus profondément dans l'épaisseur de la couche de résine 20.

Ici, le terme "pigment" peut signifier un seul pigment (un seul type de pigment) ou plusieurs pigments (plusieurs types de pigments). Le pigment peut être un pigment inorganique, par exemple comprenant un bleu de cobalt tel qu'un bleu d'aluminate de cobalt bleu spinelle, CAS 1345-16-0. Plus généralement, le pigment peut être choisi dans le groupe de pigments comprenant au moins un composé tel que : hématite et corindon, rutile, titanate, spinelle, pseudobrookite, titanate d'étain et de zinc, oxyde de chrome, oxyde de fer, pérovskite, chromate de plomb, molybdate de plomb, vanadate, bleu outremer, sulfure de cérium (III), ou pyrochlore. Le composé doit être insoluble dans la résine réticulable aux UV.

Selon une autre forme d'exécution, le pigment peut être organique ou métalorganique. Dans ce cas, la molécule constituant le pigment n'est pas soluble dans la résine, et forme des particules et une dispersion au même titre que le pigment inorganique. Des exemples de pigments organiques sont les azopigments, la phtalocyanine de cuivre, alizarin, quinacridone, Indanthrone, Chinacridon, Dioxazine, Diketopyrrolo-pyrolle.

La concentration du pigment dans la résine 20 doit permettre d'obtenir une faible absorption dans l'UV du pigment de manière à pouvoir durcir correctement la résine 20 lors de l'étape de réticulation.

Selon une forme d'exécution avantageuse, l'indice de réfraction dans l'UV du pigment est similaire à l'indice de réfraction de la résine 20. Par exemple, l'indice de réfraction dans l'UV peut être entre 1.5 et 1.6 pour les résines UV conventionnelles. La diffusion de la lumière nécessite des indices de réfraction différents entre pigment et résine. Avec une correspondance de l'indice de réfraction on diminue les phénomènes de diffusion. Cela permet de limiter les effets de diffusion de lumière et favorise la propagation du rayonnement UV dans toute l'épaisseur de la couche de résine 20. Notons que le rayonnement UV peut également se propager dans l'épaisseur de la couche de résine 20 par diffusion multiples.

Une concentration trop élevée du pigment peut limiter la profondeur de pénétration des UV durant la réticulation alors qu'une concentration trop faible donnera lieu à une couleur peu saturée. Plus généralement, la concentration du pigment dans la résine 20 permet de contrôler la couleur dans le volume de la résine 20 tout en permettant à la résine colorée d'être suffisamment transparente au rayonnement UV dans toute l'épaisseur de la couche de résine 20 de manière à permettre le durcissement de la couche de résine 20 lors de l'étape de réticulation.

Selon une forme d'exécution, la résine 20 comporte d'environ 1% en poids à environ 10% en poids, par rapport au poids total de la dispersion de résine, d'un moins un pigment en dispersion dans la résine. La résine 20 peut également comporter entre 1% et 15% en poids, ou encore 1% à 25% en poids.

Au moins un additif peut être ajouté à la résine 20 avec le pigment. Par exemple l'additif peut comprendre des dispersants et des additifs adjuvants, ajoutés à la résine 20 avec le pigment afin d'éviter que les particules de pigment ne s'agglomèrent et d'améliorer la dispersion des particules de pigment dans la résine 20. Par exemple, de tels additifs peuvent comprendre le produit Solsperse^{™} fabriqué par Lubrizol Advanced Materials, Inc (tel que Solsperse 36000, 71000, 74000, 75000, 78000, 85000, 86000, 87000). Des additifs, destinés à améliorer l'adhésion de la couche de résine 20 au substrat 10 et/ou la qualité du démoulage, peuvent également être ajoutés à la résine. Des ligands, ou toute autre chimie de surface fonctionnelle, peuvent également être utilisés maîtriser la bonne qualité de la dispersion et garantir la stabilité des pigments.

Selon une autre forme d'exécution, l'agent colorant comprend au moins un colorant. Par exemple l'agent colorant peut comprendre un colorant organique ou metallorganique. La molécule constituant le colorant étant dissoute dans la résine, une transparence suffisante dans l'UV est nécessaire afin d'assurer une bonne réticulation. Les avantages des colorants sont des couleurs intenses, une bonne homogénéité (possibilité d'avoir de la résine colorée dans les microstructures à répliquer), et un impact environnemental plus faible que les pigments inorganiques. En revanche la stabilité aux UV est moindre par rapport aux pigments inorganiques. Des exemples de colorants sont les anthaquinone, acridine, arylmethane, diarylmethane, triarylmethane, azodyes, diazonium dyes, quinone-imine, tetrazolium, thiazole, xanthene.

L'intégration de l'agent colorant dans la résine 20 permet d'obtenir une couleur plus "profonde" que dans le cas d'une résine transparente formée sur un substrat coloré.

### Motif de moule

Le motif de moule 32 (et donc le motif répliqué 22) peut comprendre des éléments de structuration, permettant de contrôler la texture de la surface et son aspect (mat, brillant, satiné). Dans ce cas, le motif de moule 32 a une dimension latérale moyenne comprise, par exemple, entre environ 1 nm et 100 µm, et un rapport d'aspect entre la hauteur des éléments de structuration et la dimension latérale moyenne compris, par exemple, entre 0 et 10, entre 0.1 et 10, entre 0.5 et 5, ou encore entre 0.5 et 2.

Le motif de moule 32 (et donc le motif répliqué 22) peut comprendre des éléments de structuration, tels que des éléments décoratifs permettant de créer des jeux de lumière en modulant spatialement la réflectivité de la surface (guillochage, soleillage). En particulier, le motif répliqué 22 peut permettre une modulation spatiale de la réflectivité de la surface (zone éclairées et zones éteinte). Dans ce cas, le motif de moule 32 a une dimension latérale moyenne comprise, par exemple, entre environ 10 µm et 5000 µm et un rapport d'aspect entre la hauteur des éléments de structuration et la dimension latérale moyenne compris, par exemple, entre 0 et 10, entre 0.1 et 10, entre 0.5 et 5, ou encore entre 0.5 et 2.

La microstructure du motif de moule 32 (et du motif répliqué 22) peut être agencée de sorte à être utilisée de manière à induire une réflectance diffuse.

Selon une forme d'exécution, le motif de moule 32 comprend un motif de décoration destiné à décorer un composant d'une montre. Par exemple, le motif de moule 32 peut comprendre un motif de décoration, par exemple un motif destiné à décorer un cadran de montre, tel qu'un motif de guillochage.

### Moule d'impression

Le moule d'impression 30 peut être obtenu en fournissant ou en produisant un outil maître fabriqué dans un matériau dur usinable, par exemple un métal ou alliage, laiton, acier ou silicium, et comprenant un motif correspondent au négatif du motif de moule 32 devant être produit. Il est également possible de répliquer le motif de moule la structure dans une résine transparente. Dans ce cas, la résine transparente est de moule d'impression 30 et comprendra un motif correspondent au négatif du motif de moule 32 devant être produit. Comme mentionné ci-dessous, surface structurée 31 du moule d'impression 30 peut être revêtue d'une couche antiadhésive.

Le motif de moule 32 peut être réalisé par usinage mécanique et/ou chimique, ciselage, perlage, microbillage, sablage, satinage, polissage, gravure laser, et/ou tribofinition (trowalisation).

Le motif de moule 32 peut également comprendre des côtes de Genève, anglage, soleillage, et/ou colimaçonnage.

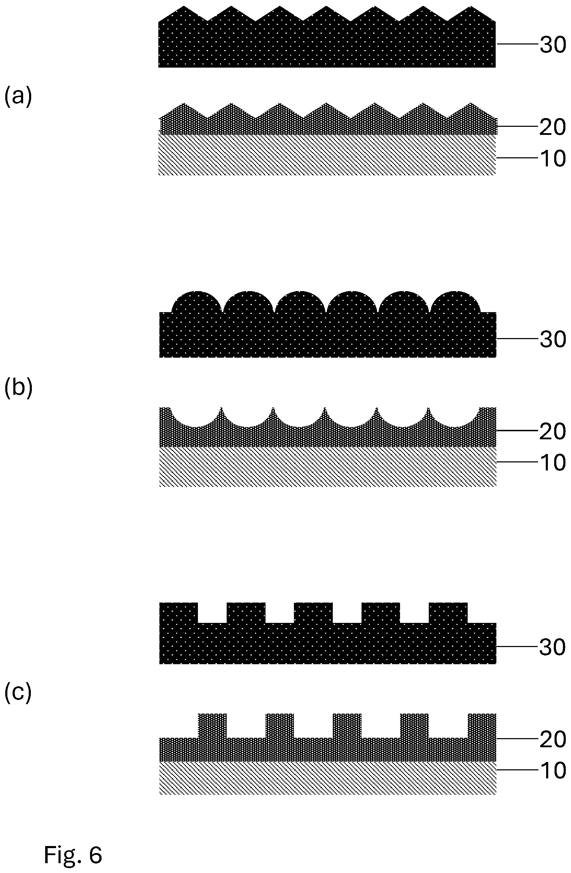

Les **figures 6a** à **6c** montrent des exemples du moule d'impression 30 avec son motif de moule 32 (haut) ainsi que le motif répliqué 22 (bas), correspondant à un motif comprenant des angles, tel que pour un motif de guillochage (figure 6a), de type hémisphérique, tel que pour un perlage (figure 6b), et de type à créneaux (figure 6c). Le flancs motif à créneaux peut comprendre des flancs verticaux ou inclinées.

Le procédé décrit ici permet de fabriquer plusieurs combinaisons uniques de motifs répliqués 22 (par exemples des motifs guillochés ou tout autre motif comportant des structures de taille nano et micrométrique) sur une résine dont la couleur peut être choisie indépendamment du motif répliqué 22.

En effet, l'ajout d'un agent colorant permet de sélectionner une couleur de la résine 20 avant la réplication, par exemple choisir l'une des couleurs pantone sur la base du choix du pigment et sa concentration dans la résine 20.

Il va de soi que la présente invention n'est pas limitée au mode de réalisation qui vient d'être décrit et que diverses modifications et variantes simples peuvent être envisagées par l'homme de métier sans sortir du cadre de la présente invention.

Par exemple le motif de moule 32 peut être fabriqué par différentes techniques de structuration comme le guillochage mais également le ciselage, perlage, microbillage et sablage, satinage, polissage, gravure laser, et/ou tribofinition.

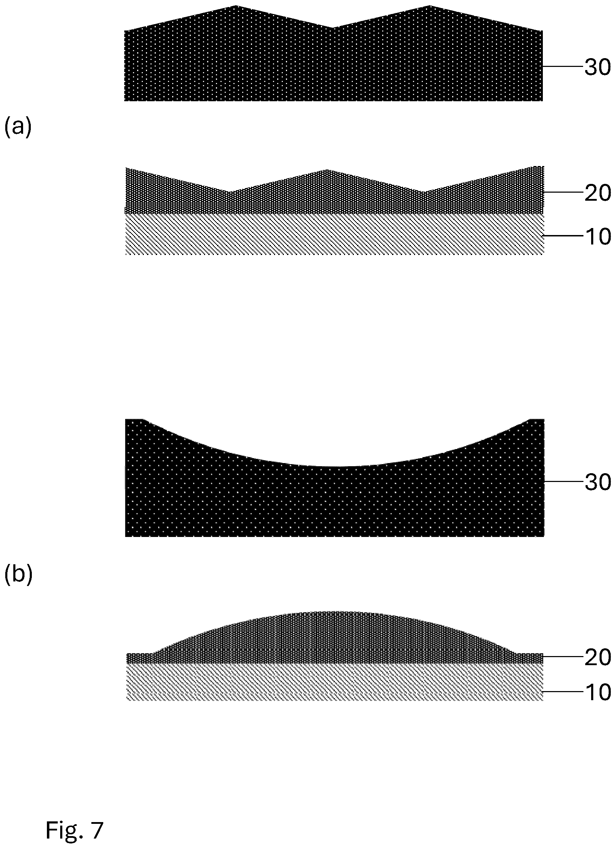

Selon une autre forme d'exécution, le motif de moule 32 peut comprendre des structures inclinées configurées pour que le motif répliqué 22 produise un effet de dégradé de couleur causé par un gradient d'épaisseur de la couche de résine 20 résultant du motif répliqué 22. Par exemple, les structures inclinées peuvent avoir une dimension latérale moyenne de plus de 1 mm. Par exemple, les structures inclinées du motif de moule 32 peuvent avoir une hauteur maximale (ou une profondeur maximale des structures inclinées dans le motif répliqué 22) égale ou similaire à l'épaisseur minimale d, par exemple égale ou plus grande que l'épaisseur minimale d. Les figures 7a et 7b montrent des exemples du moule d'impression 30 avec son motif de moule 32 (haut) ainsi que le motif répliqué 22 (bas) résultant, correspondant à structures inclinées droites (figure 7a) et courbes (figure 7b) produisant l'effet de dégradé de couleur.

Dans un autre exemple, ledit au moins un additif peut comprendre des particules diffusantes permettant d'obtenir une coloration avec un gradient de transparence, le pouvoir diffusant étant ajusté avec la concentration de particules diffusante, et le type de particules.

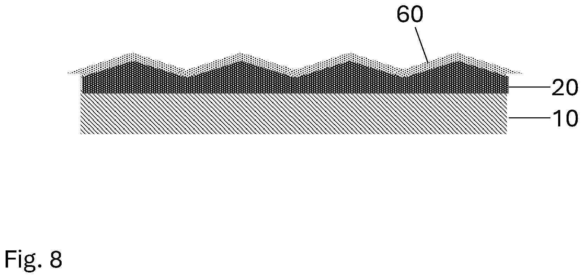

Encore dans un autre exemple illustré à la **figure 8****,** le procédé comprend également une étape de recouvrir la couche de résine 20 avec le motif répliqué 22 par une couche additionnelle 60. La couche additionnelle 60 est préférablement transparente de sorte à ne pas modifier la couleur perçue de la couche de résine 20. La couche additionnelle 60 peut être ajoutée à des fins de protection de la couche de résine 20 et/ou pour permettre d'ajuster la réflectivité de la surface du composant. La couche additionnelle 60 peut être formée par des méthodes de dépôt sous vide (PVD, ALD) ou par voie humide (spray, giclage, trempage).

Encore dans un autre exemple, le pigment peut comprendre des nanoparticules métalliques. Les nanoparticules métalliques peuvent être essentiellement constituées de métal, tel que l'argent, l'or, l'aluminium et/ou le cuivre. Les nanoparticules devraient être capables de générer un effet de résonance plasmonique de surface.

Encore dans un autre exemple, le motif de moule 32 peut comprendre un motif destiné à des application de sécurité et/ou d'anticontrefaçon, tel qu'un élément diffractif optique coloré.

Le composant fabriqué par le présent procédé peut comprendre un composant horloger, un composant de joaillerie, un composant micromécanique, un élément de sécurité et/ou d'anticontrefaçon, ou un composant décoratif. Le composant horloger peut par exemple être un cadran ou une aiguille.

Selon une forme d'exécution, le composant est un cadran. Dans ce cas, le substrat 10 peut être en laiton ou tout autre matériau approprié.

Toujours dans le cas où le composant est un cadran, le procédé peut comprendre une étape supplémentaire d'usinage de du substrat 10 comportant la résine colorée 20 avec le motif répliqué 22 (préférablement après l'étape de réticulation). L'étape d'usinage peut comprendre l'usinage d'ouvertures, par exemple afin de former un ou des trous de passage et un ou des guichets. L'étape d'usinage peut en outre comprendre une étape d'ébavurage ayant pour but de retirer l'excès de résine situé à la périphérie du cadran et qui peut résulter d'une fuite de matière entre le substrat et le moule se produisant pendant les étapes de déposition, moulage ou réticulation de la résine colorée. L'étape d'ébavurage permet ainsi de conserver les dimensions latérales originales du cadran après le dépôt et la texturation de la résine colorée. L'étape d'usinage peut en outre comprendre une étape de mise au diamètre.

On notera que le procédé de dépôt de la résine colorée 20 décrit ci-dessus est compatible avec les techniques usuelles de fabrication des cadrans horlogers qui font souvent appel à des traitements de cadran en voie liquide, par exemple lors des procédés de nettoyage ou de zaponnage (application d'une laque transparente). De ce fait, cette solution est plus facilement intégrable par les fabricants de cadrans que des traitements de coloration de cadrans réalisés par des techniques de dépôt sous vide.

La présente divulgation concerne composant obtenu par le procédé.

### Reference numéral used in the figures

- 10: substrat
- 11: surface supérieure du substrat
- 20: résine
- 21: surface d'impression de la résine
- 22: motif répliqué
- 30: moule d'impression
- 31: surface structurée
- 32: motif de moule
- 40: illumination par rayonnement UV
- 50: colonne d'estampage
- 51: support de moule
- 52: support de résine
- 53: colonne montante et descendante
- 54: moteur d'entrainement
- 55: colonne de guidage
- 56: butée
- 57: système d'irradiation
- 58: élément chauffant
- 60: couche additionnelle
- d: épaisseur minimale

## Revendications

1. Procédé de fabrication d'un composant comportant un motif de microstructure sur une résine colorée, comprenant:
fournir un moule d'impression (30) comportant un motif de moule (32) comprenant des éléments de structuration ayant une dimension de taille micrométrique et/ou nanométrique;
fournir un substrat (10) et former une couche de résine (20) colorée sur le substrat (10), la résine (20) comportant au moins un agent colorant;
répliquer sur la couche de résine (20) un motif répliqué (22) correspondant au négatif du motif de moule (32), comprenant l'application du moule d'impression (30) contre la couche de résine (20); et
réticuler la résine (20) de manière à produire une résine durcie comportant le motif répliqué (22);
dans lequel le motif de moule (32) comprend des éléments de structuration ayant une dimension latérale moyenne entre 1 nm et 5000 µm, et un rapport d'aspect entre la hauteur des éléments de structuration et la dimension latérale moyenne entre environ 0.1 et 10.

2. Le procédé selon la revendication 1,
dans lequel le motif de moule (32) peut comprend des éléments de structuration ayant une dimension latérale moyenne entre 1 nm et 100 µm ou entre 10 µm et 500 µm, et un rapport d'aspect entre la hauteur des éléments de structuration et la dimension latérale moyenne entre environ 0.1 et 10.

3. Le procédé selon la revendication 1 ou 2,
dans lequel la résine (20) est une résine photoréticulable; et
dans lequel réticuler la résine est réalisé par irradiation avec une illumination UV (40).

4. Le procédé selon la revendication 1 ou2,
dans lequel la résine (20) est une résine thermodurcissable; et
dans lequel réticuler la résine est réalisé en chauffant la résine à une température de réticulation (T_{R}) de 20 à 200°C.

5. Le procédé selon l'une des revendications 1 à 4,
comprenant en outre une étape de séparation de la résine (20), réticulée et comportant le motif répliqué (22), du moule d'impression (30).

6. Le procédé selon l'une des revendications 2 à 5,
dans lequel l'irradiance du rayonnement UV (40) est entre 10 et 500 mW/cm² afin de prendre en compte la présence du pigment dans la résine (20) et l'épaisseur de la couche de résine (20).

7. Le procédé selon l'une des revendications 2 à 6,
dans lequel le moule d'impression (30) comprend un verre ou un polymère transparent au spectre d'émission de l'illumination UV (40).

8. Le procédé selon l'une des revendications 1 à 7,
dans lequel la couche de résine colorée (20) a une épaisseur entre 10 µm et 500 µm.

9. Le procédé selon l'une des revendications 1 à 8,
dans lequel, pendant l'étape de réplication, la distance entre le moule d'impression (30) et la surface supérieure (11) du substrat (10) est contrôlée de manière à une épaisseur minimale (d), correspondant à l'épaisseur de la couche de résine (20) au niveau du creux le plus profond du motif répliqué (22), de manière à obtenir la coloration souhaitée.

10. Le procédé selon l'une des revendications 1 à 9,
dans lequel l'agent colorant comprend au moins un pigment, notamment un pigment inorganique.

11. Le procédé selon la revendication 10,
dans lequel l'indice de réfraction du pigment est entre 1.5 et 1.6.

12. Le procédé selon la revendication 10 ou 11,
dans lequel la résine 20 comporte d'environ 1% en poids à environ 10% en poids, par rapport au poids total de la dispersion de résine (20), d'un moins un pigment en dispersion dans la résine.

13. Le procédé selon l'une des revendications 1 à 12,
dans lequel le motif de moule (32) comprend des structures inclinées configurées pour que le motif répliqué (22) produise un effet de dégradé de couleur causé par un gradient d'épaisseur de la couche de résine (20) résultant du motif répliqué (22).

14. Le procédé selon l'une des revendications 1 à 13,
comprenant en outre une étape de recouvrir la couche de résine (20) avec le motif répliqué (22) d'une couche additionnelle (60) afin d'ajuster la réflectivité de la surface du composant.

15. Le procédé selon l'une des revendications 1 à 14,
dans lequel le motif de moule (32) comprend un motif de guillochage, des côtes de Genève, anglage, soleillage, ou colimaçonnage.

16. Le procédé selon l'une des revendications 1 à 15,
dans lequel le composant comprend un composant horloger, un composant de joaillerie, un composant micromécanique, un élément de sécurité et/ou d'anticontrefaçon, ou un composant décoratif.

17. Le procédé selon la revendication 16,
dans lequel le composant comprend un cadran de montre.
